# EUROPEAN PATENT SPECIFICATION

(11) **EP 4 127 885 B1**
(45) Date of publication and mention of the grant of the patent: **26.06.2024**
(21) Application number: 20726307.0
(22) Date of filing: 04.05.2020
(51) Int. Cl.: G06F 3/041, G06F 1/16, H03K 17/97

(54) **FLEXIBLE DISPLAY STRUCTURES FOR USER EQUIPMENT**
FLEXIBLE ANZEIGESTRUKTUREN FÜR BENUTZERGERÄTE
STRUCTURES D'AFFICHAGE SOUPLES POUR ÉQUIPEMENT UTILISATEUR

(43) Date of publication of application: 08.02.2023
(73) Proprietor: Huawei Technologies Co., Ltd., Shenzhen, Guangdong 518129 (CN)
(72) Inventor: EROMAKI, Marko, 16440 Kista (SE)
(74) Representative: Epping - Hermann - Fischer
(86) International application number: PCT/EP2020/062234
(87) International publication number: WO 2021/223832

(56) References cited:
- WO-A1-2018/201704
- JP-A- 2006 242 986
- US-A1- 2013 241 718
- US-A1- 2016 070 304
- US-A1- 2019 391 649

## Description

### TECHNICAL FIELD

Aspects relate, in general, to a flexible display surface, and more specifically, although not exclusively, to deformable flexible display surfaces for use in mobile devices such as smart devices.

### BACKGROUND

Electronic devices such as cellular telephones, media players, and computers are often provided with displays. Some electronic devices may be provided with flexible display technologies that allow displays to be bent. For example, flexible displays may be formed using flexible organic light-emitting diode (OLED) display technology that enable display screens to fold or roll around an axis. Examples include user equipment in which a display can be folded from a closed to an open configuration. In the open configuration, the user equipment can take on the form-factor of a tablet device, whereas in the closed configuration the user equipment can take on the form-factor of a mobile device such as a mobile telephone for example.

Interactions between devices and humans occur using interfaces that enable users to control the devices. In the context of devices with displays, such user interfaces can take the form of graphical user interfaces that enable users to interact with a device by way of information presented to the user on the display. The information that is presented can take a multitude of different forms, ranging from simple textual indications to complex three-dimensional graphical renderings used for gameplay and so on.

Although a display may be configured to fold or bend, and some displays are even configured to present information to a user in whilst they are in a curved form (e.g. curved monitors or television displays), the displays form a generally planar, uniform or smooth surface. As such, information presented to the user is geared for display on such a uniform surface and any user input, which may be directly input using the display in the case of devices with, e.g., touch displays, reflects the fact the surface is smooth.

US20190391649A1 discloses a method and apparatus for generating haptic surface texture with a deformable surface layer. The haptic device includes a flexible surface layer, a haptic substrate, and a deforming mechanism. The flexible surface layer is made of elastic materials and is capable of reconfiguring its surface characteristics. The haptic substrate provides a first pattern in response to a first activating signal. Alternatively, the haptic substrate is capable of providing a second pattern in accordance with a second activating signal. The deforming mechanism is configured to change the flexible surface from a first surface characteristic to a second surface characteristic in accordance with the first pattern.

WO2018201704A1 A discloses a flexible display device comprising a flexible display panel; a shape memory structure disposed on the flexible display panel, the shape memory structure including a shape memory component including a first memory layer, a first heat insulating layer, and a second stacked in a direction away from the flexible display panel a memory layer, the first memory layer and the second memory layer have a shape memory function, and the first memory layer has a first memory shape, and the second memory layer has a second memory shape, the first memory shape is different from the second memory shape.

US20130241718A1 discloses mobile devices having haptic interfaces located on an edge or back of mobile phones for selectively controlling and varying surface texture and/or force levels. The haptic interfaces may allow for haptic interaction with the user of the mobile device when audio or visual feedback is not practical. The haptic interface may be an electro-mechanical system that may include a matrix or array of individually addressable actuators that can convey haptic information through the deformation of a flexible surface or membrane covering the array of individually addressable actuators. The array of "individually addressable" actuators may provide each actuator the ability to be separately addressable or addressable as a group (i.e. two or more) actuators.

### SUMMARY

According to a first aspect, there is provided a flexible display structure for user equipment, the display structure comprising a deformable display surface and an actuation structure configured to deform the deformable surface, the actuation structure comprising an actuation layer comprising multiple individually addressable electrically conductive actuators each of which being so positioned as to deform a selected portion of the display surface in a first direction, a biasing layer comprising multiple resiliently biased portions, each one of which so positioned as to correspond with an actuator of the actuation layer, and so configured as to accompany deformation of the deformable surface at a selected portion, each of the resiliently biased portions configured to urge the corresponding actuator of the actuation layer in a second direction opposite to the first direction, wherein the actuation layer is disposed between the deformable display surface and the biasing layer.

Each actuator can be addressed so as to deform a selected portion of the display surface, with a corresponding biased portion urging the actuator to return to its initial position which corresponds to a state in which the selected portion of the display surface is not deformed. The structure can be used with mobile devices, which require a thin, low cost structure that will not interfere with touch features of the device. The actuation and biasing layers require no complicated electronic components and may therefore be easily fabricated. That is, for example, the resiliently biased portions of the biasing layer can be formed from spring-type elements in a sheet of elastic material.

Each of the individually addressable electrically conductive actuators comprises an anfractuous arm with an electrical connection to a feed layer configured to provide an electrical current, wherein the feed layer is disposed between actuation layer and biasing layer.

That is, the actuators can comprise geometrically tortuous arms. Such a shape provokes heating due to the effects of resistance upon application of an electrical current. As such, the arms may twist and turn but are (electrically) continuous, such as forming a zigzag shape. The benefits of the geometric shape are many-fold: the arms take up less space, and the shape provokes a quicker response compared to, e.g., the case in which the arm was straight. The arms may take on many different shapes and configurations. However, a zigzag/snaked/curved shape provides a larger material length for an arm (compared with, e.g., a straight arm). As the material actuation can be based onto contraction (i.e. a length change upon heating), a longer material shape produces more shear displacement respective to the static bias layer. This results larger bending movement for the arm tip. As such, a relatively small arm can therefore result in a deformation of the order of 1-5mm of a selected portion of a display surface, such as a deformation of the order of 2-5mm.

In an implementation, each of the arms can further comprise a mechanical connection to the display surface. Such a mechanical connection can be a glue spot for example, that fixedly connects the end portion of an arm to a selected portion of the display surface. Fixing the extremity of an arm to the display surface maximises the amount of deformation of the display surface for a given deflection of the arm. Each of the actuators is configured to deform upon application of an electrical current and/or thermal energy. In an example, application of an electrical signal causes resistive heating in an arm, thus increasing the temperature of the material from which the arm is formed thereby provoking a deformation by way of, e.g., contraction of the material. In another example, the arm may be heated indirectly by way of a heat source.

The actuation layer can be formed from a shape memory alloy or polymer material. The biasing layer can be formed from a metallic material. Alternatively, the biasing layer may be formed from a shape memory alloy or polymer material. In an implementation, the actuators can be regularly distributed in an array in the actuation layer over an area corresponding to an area of the deformable display surface.

A display can be deformed to mimic the behaviour of, e.g., protruding keys of a keyboard. As such, a regularity to the actuators is beneficial in order to enable such features to be provided. Of course, the provision of an irregular distribution of actuators is also possible.

The actuation layer and the biasing layer can be mechanically connected. For example, the layers may be fixed by way of glue points or other mechanical fixings such as rivets for example.

According to an example, each of the multiple individually addressable electrically conductive actuators can comprise a magnetic portion. The magnetic portion of an actuator may be so positioned as to interact with a static sensor.

That is, a magnetic portion can comprise a magnet that is disposed on a part of an arm forming an actuator, or magnetised region of the arm. The sensor can be disposed in another layer, such as the feed layer for example, so that (relative to the magnetic portions) it is static. Thus, movement of an arm can be sensed via the interaction between the magnetic portion and the sensor, which may be a Hall-effect sensor for example. This can enable, for example, detection of the force or speed with which a deformed portion of the display is pressed. This provides many applications, e.g. in the field of gaming and analogue keypads and keyboards.

According to a non-claimed aspect, there is provided a method for deforming a selected portion of a touch display of user equipment, the method comprising applying an electrical current to a first actuator disposed at a first position in an actuation layer of a display structure of the user equipment so as to induce resistive heating of the first actuator whereby to cause the selected portion of the touch display to deform in a first direction, and removing the electrical current so as to enable a resiliently biased element at the first position to cause the selected portion of the touch display to return an undeformed state.

The selected actuator can be formed from a shape memory effect alloy or polymer material configured to deform according to a temperature-induced phase transformation profile. For example, above a threshold temperature, the material can contract, thereby provoking a deformation of an arm formed from the material. An electrical current can be applied to a second actuator disposed at the first position in the actuation layer so as to induce resistive heating of the second actuator whereby to cause the selected portion of the touch display to deform in a second direction.

That is, the actuator may be composed of two layers of smart material that can be structured to deform or flex in opposing directions depending on the application of a current to one or other of the layers. For example, one layer can be configured to contract upon application of current thereby inducing an upward deformation of the actuator, whilst (subject to removal of current in the first layer), application of electrical current to a smart material in the other layer can cause it to contract thereby inducing an downward deformation of the actuator. Accordingly, response times may be improved (e.g. for the case where a deformation is to be reversed), and varying degrees of deformation may be applied by tuning the degree of resistive heating in a layer so as to control the amount by which a layer flexes.

In an example, the method can further comprise applying an electrical current to a third actuator disposed at a second position in the actuation layer so as to induce resistive heating of the third actuator whereby to cause a second selected portion of the touch display to deform in a first direction, and removing the electrical current so as to enable a resiliently biased element at the second position to cause the second selected portion of the touch display to return an undeformed state.

Beneficially, as actuators are individually addressable, groups may be energised in order to cause various parts of the display to deform (either simultaneously or at different times etc.).

The method can further comprise generating a measure representing a force applied to the selected portion of the touch display when in a deformed state. In this way, an analogue measure of applied force can be determined. This can spawn multiple different use cases for a deformable display surface as described herein.

According to a third aspect, there is provided user equipment comprising a flexible display structure as provided here. The deformable display surface can be a touch surface configured to receive user input. In an example, the user equipment can comprise a processor communicatively coupled to a memory, the process configured to generate an output signal representing a degree of deformation of the selected portion of the display surface. The processor may be further configured to determine an amount of deformation of the selected portion on the basis of a measure of deflection of the selected portion generated by a magnetic sensing structure.

### BRIEF DESCRIPTION OF THE DRAWINGS

For a more complete understanding of the present disclosure, reference is now made, by way of example only, to the following descriptions taken in conjunction with the accompanying drawings, in which:
Figure 1 is a schematic representation of a flexible display structure according to an example;
Figure 2 is a schematic representation of a portion of an actuation layer according to an example;
Figure 3 is a schematic representation of the process of deformation of an arm of an actuator according to an example;
Figure 4 is a further schematic representation of the process of deformation of an arm of an actuator according to an example;
Figure 5 is a schematic representation of the underside of the portion depicted in figure 2 according to an example;
Figure 6 is a schematic representation of the process of deformation of an arm of an actuator according to an example; and
Figure 7 is a schematic representation of user equipment according to an example.

### DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein. Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

User equipment can include a mobile device, such as a mobile telephone or tablet for example. In general, because of their size and the demands on their cost and functionality such devices use of components that are low cost, mass-producible, have reasonable power consumption, are electro-magnetic interference friendly and generate no audible noise. In the case of a flexible display for such devices, such a display should also allow a degree of deformation that enables the flexibility suggested by the device and may also need to enable touch inputs and/or haptic feedback. As such, there are limitations on a flexible display structure that hinder modifications that may go to improve user experience.

According to an embodiment, there is provided a flexible display structure for user equipment.

The display structure comprises a deformable display surface and an actuation structure configured to deform the deformable surface. The actuation structure comprises an actuation layer that includes multiple individually addressable electrically conductive actuators. Each of the actuators is so positioned as to deform a selected portion of the display surface in a first direction. For example, an actuator may be configured to deform a selected portion of a flexible display in a direction normal to the plane of the display surface. A biasing layer is provided, which comprises multiple resiliently biased portions, each one of which so positioned as to correspond with an actuator of the actuation layer, and so configured as to accompany deformation of the deformable surface at a selected portion. Each of the resiliently biased portions is configured to urge the corresponding actuator of the actuation layer in a second direction opposite to the first direction. For example, a resiliently biased portion can be used to cause an actuator to return to a state which corresponds to no deformation of the selected portion of the display. That is, when causing deformation, an actuator and a corresponding resiliently biased portion can be in a first state. When not causing deformation, an actuator and a corresponding resiliently biased portion can be in a second state. The actuation layer is disposed between the deformable display surface and the biasing layer.

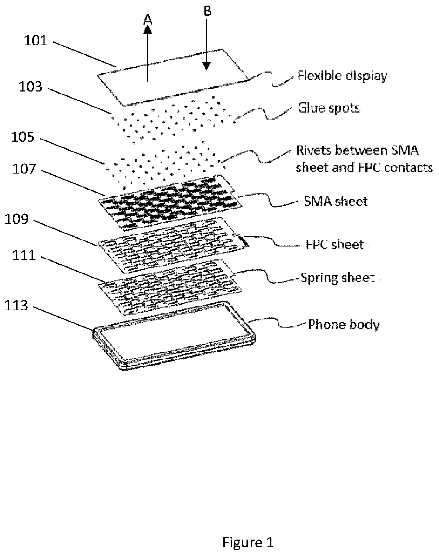

Figure 1 is a schematic representation of a flexible display structure according to an example. In the example of figure 1, user equipment 113, in the form of a mobile/smart device, comprises a deformable display surface 101. The deformable display surface 101 can comprise an OLED display for example. An actuation structure is provided configured to deform the deformable display surface 101. The actuation structure comprises an actuation layer 107. The actuation layer 107 comprises multiple individually addressable electrically conductive actuators each of which so positioned as to deform a selected portion of the display surface 101 in a first direction, A. In the example of figure 1, the actuation layer 107 comprises a smart memory alloy (SMA) sheet. The SMA sheet 107 can comprise an alloy such as copper-aluminium-nickel, nickel-titanium (NiTi), an alloy of zinc, copper, gold and iron, or an iron-based and copper-based material such as Fe-Mn-Si, Cu-Zn-Al and Cu-Al-Ni. The SMA sheet 107 exhibits a memory effect that sees it reversibly change between states in the presence of temperature changes. For example, at a first temperature, the SMA material can be in a first state and when at a second temperature can be in a second state. A state of the material can correspond to a degree of deformation of the material. So, for example, at room temperature (e.g. around 21 deg. C) the material can be in a 'rest' state in which no deformation is apparent. When heated (or cooled, depending on the material in question) to a threshold temperature, the material can deform into a second state. Reverting to the first temperature will see the material return to a pre-deformed state.

Accordingly, in the context of the example depicted in figure 1, the multiple individually addressable electrically conductive actuators of the SMA layer 107 can each be configured to individually deform when subjected to a change in temperature. Such deformation of one of the individually addressable electrically conductive actuators can cause deformation of a selected portion of the display surface 101 in a first direction, A. For example, heating the actuator in question to a threshold temperature can cause the actuator to deform in a direction A thereby resulting in a corresponding deformation of a portion of the display surface. Once below the threshold temperature, such that the actuator reverts to a pre-deformed state, the corresponding portion of the display surface will also return to its undeformed (e.g. flat) state. In an example, each of the individually addressable electrically conductive actuators of the layer 107 are connected to the display surface using adhesive 103, such as in the form of glue dots that adhere each one of the actuators to portions of the display surface, thereby enabling selected portions of the display surface to be deformed by corresponding actuators. Put another way, each one of the actuators is fixedly attached to the display surface such that when an actuator is caused to deform, the portion of the display surface to which that actuator is attached also deforms.

In figure 1, a biasing layer 111 is provided. The biasing layer 111 comprises multiple resiliently biased portions, each one of which so positioned as to correspond with an actuator of the actuation layer 107. Accordingly, upon deformation of an actuator, a corresponding resiliently biased portion deforms. That is, each resiliently biased portion is so configured as to accompany deformation of an actuator of the deformable surface at a selected portion. Thus, when an actuator is heated to a threshold temperature so that it deforms in direction A, a resiliently biased portion corresponding to the actuator in question deforms with the actuator. Once below the threshold temperature, such that the actuator reverts to a pre-deformed state, the corresponding resiliently biased portion is so configured as to urge the actuator in a second direction (B) opposite to the first direction so as to cause the actuator to revert to its first, pre-deformed, state. Although an actuator may revert to such a state of its own accord, the action of the resiliently biased portion means that the return to the first state is achieved more quickly, which is advantageous in the context of the device 113 where display surface 101 deformations may be required to be short lived depending on the use case.

In figure 1, the actuation layer 107 is disposed between the deformable display surface 101 and the biasing layer 111. A further layer in the form of a flexible printed circuit (FPC) layer 109 providing a feed layer can be interposed between the actuation layer 107 and the biasing layer 111. The FPC layer 109 can comprise multiple electrical contacts to the actuation layer 107. That is, in an example, the FPC layer 109 provides an electrical contact for each actuator of the actuator layer 107. The connection can be provided by way of a metal rivet in a layer of rivets 105 with a common ground.

The actuation structure and flexible display, which can be housed in the body of the mobile device 113, thus defines an electromechanically stacked assembly of sheet-based elements that are thin and easy manufacturability (using for example, photo- or chemical etching) for detail geometry, as will be described in more detail below. Underneath the flexible display 101 is provided the actuation (SMA) sheet layer 107, which can be coupled to a bottom surface of the display 101 by spot-gluing. The FPC sheet layer 109 can comprise electrical connections to the actuator SMA sheet layer 107 such that there exists one such connection for each actuator that is enabled by way of, e.g., a metal rivet and one common grounding for the overall sheet. The biasing layer 111 can be electrically isolated from the SMA sheet layer 107 and is configured to perform return movement for actuators when they are deactivated. In an example, the layers of the structure described with reference to figure 1 can be connected together by, e.g., by glue. FPC layer 109 can comprise a pinout-interface for external control. In an example, the structure described with reference to figure 1 is accommodated into the cavity of the body of the mobile device 113, and since it can be configured to be around 0.8-1.0 mm, does not significantly impact the form factor of the device.

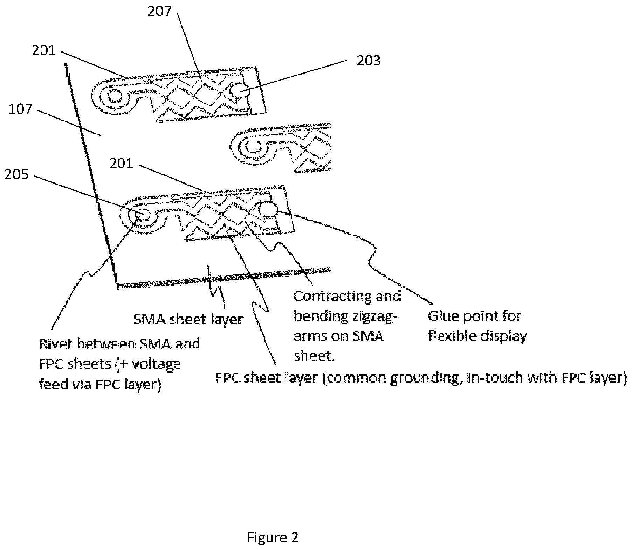

Figure 2 is a schematic representation of a portion of an actuation layer 107 according to an example. In the example of figure 2 two actuators 201 of the layer 107 are depicted in more detail. Multiple such actuators can be provided over the area defined by the actuator layer 107 and each actuator 201, being individually addressable, is therefore able to deform a selected portion of the display surface 101.

In an example, an actuator 201 comprises a glue point 203 to enable the actuator 201 to be fixedly connected to a selected portion of the underside of the display surface 101. A rivet point 205 enables a rivet or other such conductive element to be used to provide an electrical connection between the actuator 201 and the FPC layer 109. This also provides a fixed mounting point for the actuator 201 to the FPC layer 109. As can be seen in figure 2, each of the individually addressable electrically conductive actuators 201 comprises an anfractuous arm 207 with an electrical connection 205 to the feed layer 109 that is configured to provide an electrical current. An electrical current supplied to an actuator 201 provokes heating of the actuator arm 207 due to the effects of resistance upon application of the current. That is, the actuators comprise geometrically tortuous arms 207, the shape of which provokes heating due to the effects of resistance upon application of an electrical current. As such, the arms 207 may twist and turn but are (electrically) continuous, such as forming a zigzag shape as shown in figure 2 for example. The benefits of the geometric shape include the fact that the arms 207 take up less space, and that the shape provokes a quicker response to an applied electrical current than that compared to the case in which an arm was straight for example. Furthermore, a zigzag/snaked/curved shape provides a larger material length for an arm (compared with, e.g., a straight arm). Thus, in the case that the deformation of an actuator 201 is based on material contraction (i.e. a length change of an arm 207 upon heating), a longer material shape produces more shear displacement respective to the static bias layer 111, thereby resulting in a larger bending movement for the tip of an arm 207 near the portion 203 which is fixed to the display surface. Accordingly, it is possible to perform a relatively large deformation of a selected portion of the display surface of the order of 1-5mm, such as a deformation of the order of 2-5mm for example. The shape of the arm 207 depicted in figure 2 is not intended to be limiting. For example, the arm may comprise some other zigzag, snaked or curved shape or combination thereof.

According to an example, during activation, a specific actuator 201 or a plurality of actuators are supplied with power by way of a voltage applied via the appropriate FPC external pinout(s) 205 routed to the actuator layer 107. In the case of single actuator, such routing addresses one power line to the riveted root connection point 205 of an arm 207 while the other signal is connected to the surrounding SMA sheet surface 107. As the SMA material from which the layer 107 is formed is activated by an increase in thermal energy, the arm(s) 207 are heated up first (compared to the rest of the payer 107) due to higher internal resistance, while the surrounding uniform layer 107 remains inactivated. In the present context, activation can mean contraction of the material or activating some other higher-temperature, austenitic, "memorized" state.

Due to the mutual coupling between the layers of the structure, shear movements are prevented. Accordingly, when an actuator 201 contracts, the lower layers follow the movement thereby creating a bending action on the arm 207. The tip (generally 203) of the arm 207 will then move in the direction A (upwards). By having an array of actuators 201, the whole of the display surface 1010 can be manipulated locally in direction A.

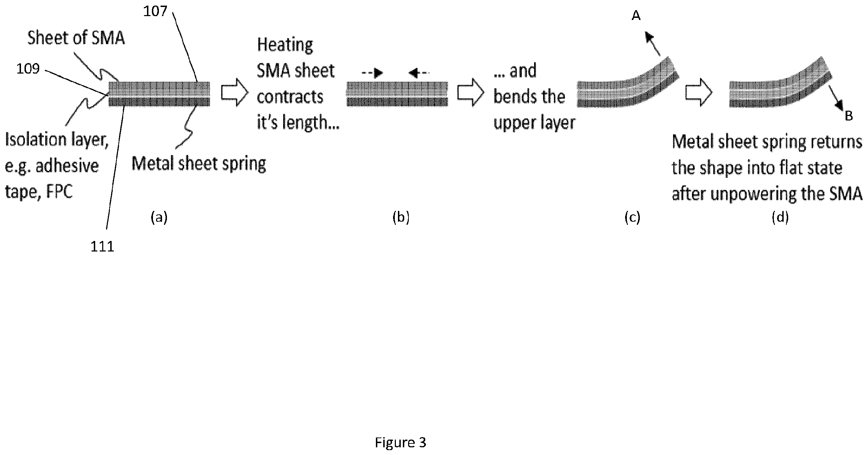

Figure 3 is a schematic representation of the process of deformation of an arm of an actuator according to an example. In figure 3a, actuator layer 107 (comprising actuators 201) is depicted. The biasing layer 111 and feed layer 109 are depicted. In figure 3b, an electrical signal is supplied to the connection point 205 of an actuator 201 in order to provoke heating of the arm 207 of that actuator 201. As the arm heats up due to the resistive heating experienced as a result of the applied electrical signal, the arm 207 contracts, as shown in figure 3c, thereby resulting in (according to the example of figure 3) movement of the arm in the direction shown, which causes to the selected portion of the display surface 101 to which the point 203 is attached to deform in direction A. Upon removal of the electrical signal, a resiliently biased portion in bias layer 111 corresponding to the activated actuator 201 causes the actuator 201 to revert to its pre-deformed (flat) state, thereby causing the display surface to also revert to its pre-deformed (flat) state.

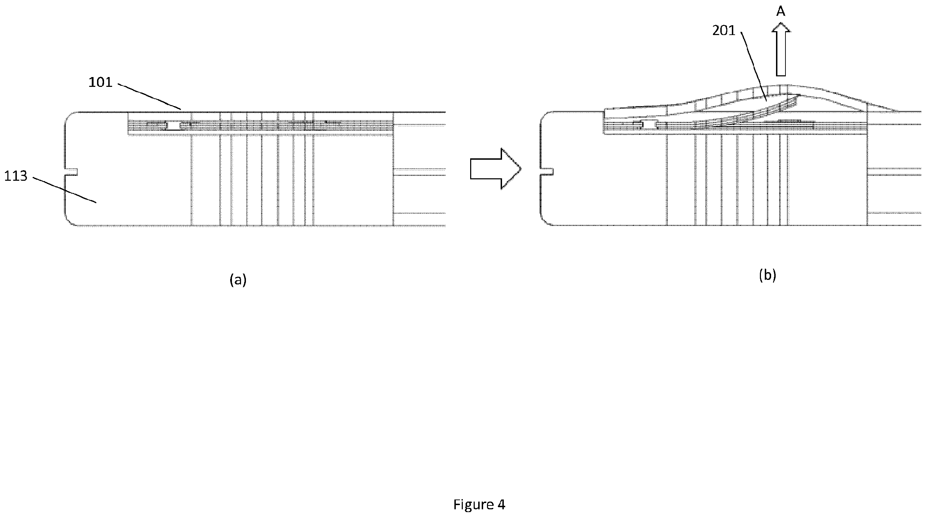

Figure 4 is a further schematic representation of the process of deformation of an arm of an actuator according to an example. In the example of figure 4, figure 4a shows a portion of a display surface 101 of a device 113 in a state in which it is not deformed. Figure 4b shows deformation of the selected portion of the display surface 101 in the direction A as a result of deformation of an arm of an actuator 201 located at the selected position.

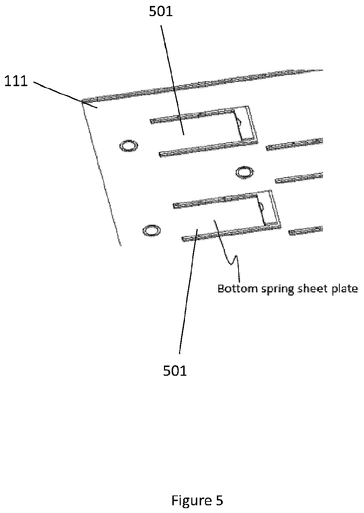

Figure 5 is a schematic representation of the underside of the portion depicted in figure 2 according to an example. A resiliently biased portion 501 is depicted, which in the example of figure 5 can be in the form a spring-like element comprising a length of biasing layer 111 that extends over substantially the length of an arm 207 of an actuator 201.

According to an example, the biasing layer 111 may be in the form an SMA layer that can be configured to cause movement of an arm 207 of an actuator in direction B upon application of an electrical signal that heats the material such that contraction thereof occurs in a direction that is opposite to the contraction experienced by layer 107 upon application of an electrical signal.

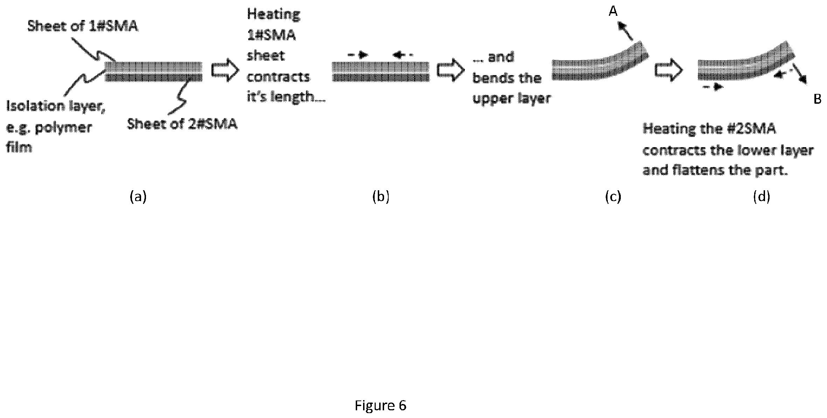

Figure 6 is a schematic representation of the process of deformation of an arm of an actuator according to an example. In the example of figure 6, layer 111 is provided in the form of an SMA layer. The process to deform an arm in direction A proceeds as described with respect to figure 3. However, upon removal of the electrical signal, a resiliently biased portion takes the form an additional arm in layer 111 formed from SMA material that is so configured to contract upon application of an electrical signal, whereby to cause that arm to contract. As a result of the relative disposition of the layers, this contraction causes the arm in layer 111 to 'pull' the actuator 201 so as to revert to its pre-deformed (flat) state, thereby causing the display surface to also revert to its pre-deformed (flat) state.

In an example, deformation of a selected portion of a display surface can be used to emphasise information presented to a user. For example, in the case of a smart device for example, deformation can be used to make keys of a virtual keyboard pop out of the display, or enable certain portions relating to control features of a game pop out. Further, a display may be deformed in order to provide a more immersive experience for a user, such as by causing the display to curve in at the edges so as to mimic a curved display for example.

In addition to pure mechanical shape changing (graphics) screen deformation, sensing capability can be integrated to the display surface. For example, if a flexible display contains, e.g., a capacitive touch film, then the user feedback can be detected by the specific screen deformation location. If the flexible display contains, e.g., pressure sensing film or the actuation platform comprises a closed loop feedback function (such as small magnets attached to the moving tips of bending arms with embedded (static) hall-elements on the FPC layer for example), an analogue type UI touch screen can be provided in which subtle movements and actuations by a user can be detected. This would mean that when a portion of a display surface screen is activated into an embossed (deformed) state, pressing these "bumps" with an external force can be detected by the display surface. Several applications can utilize this feature such as, e.g., analogue keyboards or gaming pads, pedals and other controls. Additionally, a tactile effect for a, e.g., finger press can be generated using a motor or specific actuator such as a piezoelectric or solenoid actuator inside the device 113 to emphasize the finger contact.

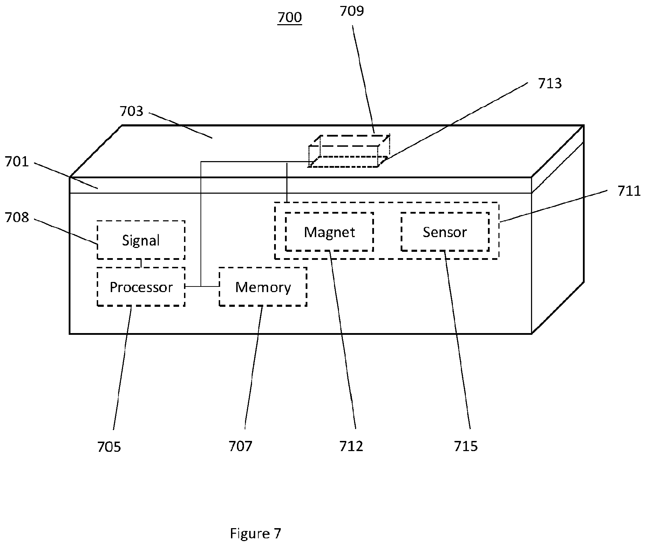

Figure 7 is a schematic representation of user equipment according to an example. User equipment 700, such as a smart device including a mobile telephone or tablet device for example, comprises a flexible display structure 701. The structure 701 can be a display structure as described above with reference to figures 1 to 6. As such, a deformable display surface 703 can form a touch surface that is configured to receive user input. In the example of figure 7, the user equipment 700 further comprises a processor 705 communicatively coupled to a memory 707. The processor is configured to generate an output signal 708 representing a degree of deformation of a selected portion 709 of the display surface 703, which deformation can be generated according to the process described above. In an example, the processor can determine an amount of deformation of the selected portion 709 on the basis of a measure of deflection of the selected portion 709 generated by a magnetic sensing structure 711. As noted above, such a structure 711 can comprise a magnet or magnetised portion 712 provided on an arm of an actuator 713 that is configured to move in unison with the arm as deformation thereof occurs, and a sensor 715. The movement of the magnet or magnetised portion 712 can be detected by the sensor 715, such as a Hall detector for example, in order to generate a measure of the degree of deflection of the arm and thus the amount of deformation of the selected portion. The measure can be used to determine the amount of deflection (or deformation) as well as the rate of such deflection, which may be use to provide an indication as to the force exerted on the portion 709 by a user for example.

## Claims

1. A flexible display structure for user equipment, the display structure comprising a deformable display surface (101) and an actuation structure configured to deform the deformable surface, the actuation structure comprising:
an actuation layer (107) comprising multiple individually addressable electrically conductive actuators each of which being so positioned as to deform a selected portion of the display surface in a first direction; **characterised by**
a biasing layer (111) comprising multiple resiliently biased portions, each one of which so positioned as to correspond with an actuator of the actuation layer (107), and so configured as to accompany deformation of the deformable surface at a selected portion, each of the resiliently biased portions configured to urge the corresponding actuator of the actuation layer (107) in a second direction opposite to the first direction,
wherein the actuation layer (107) is disposed between the deformable display surface (101) and the biasing layer (111), wherein each of the individually addressable electrically conductive actuators comprises an anfractuous arm (207) with an electrical connection to a feed layer configured to provide an electrical current, wherein the feed layer is disposed between actuation layer (107) and biasing layer (111).

2. The flexible display structure as claimed in claim 1, wherein each of the arms (207) further comprises a mechanical connection to the display surface.

3. The flexible display structure as claimed in any preceding claim, wherein each of the actuators is configured to deform upon application of an electrical current and/or thermal energy.

4. The flexible display structure as claimed in any preceding claim, wherein the actuation layer (107) is formed from a shape memory alloy or polymer material.

5. The flexible display structure as claimed in any preceding claim, wherein the biasing layer (111) is formed from a metallic material.

6. The flexible display structure as claimed in any of claims 1 to 4, wherein the biasing layer (111) is formed from a shape memory alloy or polymer material.

7. The flexible display structure as claimed in any preceding claim, wherein the actuators are regularly distributed in an array in the actuation layer (107) over an area corresponding to an area of the deformable display surface (101).

8. The flexible display structure as claimed in any preceding claim, wherein the actuation layer (107) and the biasing layer (111) are mechanically connected.

9. The flexible display structure as claimed in any preceding claim, wherein each of the multiple individually addressable electrically conductive actuators comprises a magnetic portion.

10. The flexible display structure as claimed in claim 9, wherein the magnetic portion of an actuator is so positioned as to interact with a static sensor

11. User equipment (700) comprising a flexible display structure as clamed in any of claims 1 to 10.

12. User equipment (700) as claimed in claim 11, wherein the deformable display surface (101) is a touch surface configured to receive user input.

13. User equipment (700) as claimed in claim 11 or 12, further comprising a processor (705) communicatively coupled to a memory (707), the processor (705) configured to generate an output signal representing a degree of deformation of the selected portion of the display surface.

14. User equipment (700) as claimed in claim 13, wherein the processor (705) is further configured to determine an amount of deformation of the selected portion on the basis of a measure of deflection of the selected portion generated by a magnetic sensing structure.

## Patentansprüche

1. Flexible Anzeigestruktur für eine Benutzereinrichtung, wobei die Anzeigestruktur eine verformbare Anzeigeoberfläche (101) und eine Betätigungsstruktur, die konfiguriert ist, um die verformbare Oberfläche zu verformen, umfasst, wobei die Betätigungsstruktur umfasst:
eine Betätigungsschicht (107), die mehrere individuell adressierbare elektrisch leitfähige Betätigungselemente umfasst, von denen jedes so positioniert ist, dass es einen ausgewählten Abschnitt der Anzeigeoberfläche in einer ersten Richtung verformt; **gekennzeichnet durch** eine Vorspannschicht (111), die mehrere elastisch vorgespannte Abschnitte umfasst, von denen jeder so positioniert ist, dass er einem Betätigungselement der Betätigungsschicht (107) entspricht, und so konfiguriert ist,
dass er eine Verformung der verformbaren Oberfläche an einem ausgewählten Abschnitt begleitet, wobei jeder der elastisch vorgespannten Abschnitte konfiguriert ist, um das entsprechende Betätigungselement der Betätigungsschicht (107) in eine zweite Richtung entgegengesetzt zu der ersten Richtung zu drängen,
wobei die Betätigungsschicht (107) zwischen der verformbaren Anzeigeoberfläche (101) und der Vorspannschicht (111) angeordnet ist, wobei jeder der individuell adressierbaren elektrisch leitfähigen Betätigungselemente einen gewundenen Arm (207) mit einer elektrischen Verbindung mit einer Zufuhrschicht, die konfiguriert ist, um einen elektrischen Strom bereitzustellen, umfasst, wobei die Zufuhrschicht zwischen der Betätigungsschicht (107) und der Vorspannschicht (111) angeordnet ist.

2. Flexible Anzeigestruktur nach Anspruch 1, wobei jeder der Arme (207) ferner eine mechanische Verbindung mit der Anzeigeoberfläche umfasst.

3. Flexible Anzeigestruktur nach einem der vorstehenden Ansprüche, wobei jedes der Betätigungselemente konfiguriert ist, um sich bei einem Anlegen eines elektrischen Stroms und/oder einer Wärmeenergie zu verformen.

4. Flexible Anzeigestruktur nach einem der vorstehenden Ansprüche, wobei die Betätigungsschicht (107) aus einer Formgedächtnislegierung oder einem Polymermaterial ausgebildet ist.

5. Flexible Anzeigestruktur nach einem der vorstehenden Ansprüche, wobei die Vorspannschicht (111) aus einem metallischen Material ausgebildet ist.

6. Flexible Anzeigestruktur nach einem der Ansprüche 1 bis 4, wobei die Vorspannschicht (111) aus einer Formgedächtnislegierung oder einem Polymermaterial ausgebildet ist.

7. Flexible Anzeigestruktur nach einem der vorstehenden Ansprüche, wobei die Betätigungselemente in einem Array in der Betätigungsschicht (107) über einen Bereich, der einem Bereich der verformbaren Anzeigeoberfläche (101) entspricht, regelmäßig verteilt sind.

8. Flexible Anzeigestruktur nach einem der vorstehenden Ansprüche, wobei die Betätigungsschicht (107) und die Vorspannschicht (111) mechanisch verbunden sind.

9. Flexible Anzeigestruktur nach einem der vorstehenden Ansprüche, wobei jedes der mehreren individuell adressierbaren elektrisch leitfähigen Betätigungselemente einen magnetischen Abschnitt umfasst.

10. Flexible Anzeigestruktur nach Anspruch 9, wobei der magnetische Abschnitt eines Betätigungselements so positioniert ist, dass er mit einem statischen Sensor interagiert.

11. Benutzereinrichtung (700), die eine flexible Anzeigestruktur nach einem der Ansprüche 1 bis 10 umfasst.

12. Benutzereinrichtung (700) nach Anspruch 11, wobei die verformbare Anzeigeoberfläche (101) eine Berührungsoberfläche ist, die konfiguriert ist, um eine Benutzereingabe zu empfangen.

13. Benutzereinrichtung (700) nach Anspruch 11 oder 12, die ferner einen Prozessor (705), der mit einem Speicher (707) kommunikativ gekoppelt ist, umfasst, wobei der Prozessor (705) konfiguriert ist, um ein Ausgangssignal, das einen Grad der Verformung des ausgewählten Abschnitts der Anzeigeoberfläche darstellt, zu erzeugen.

14. Benutzereinrichtung (700) nach Anspruch 13, wobei der Prozessor (705) ferner konfiguriert ist, um ein Ausmaß der Verformung des ausgewählten Abschnitts anhand eines Maßes einer Ablenkung des ausgewählten Abschnitts, der durch eine magnetische Erfassungsstruktur erzeugt wird, zu bestimmen.

## Revendications

1. Structure d'affichage flexible pour un équipement utilisateur, la structure d'affichage comprenant une surface d'affichage déformable (101) et une structure d'actionnement conçue pour déformer la surface déformable, la structure d'actionnement comprenant :
une couche d'actionnement (107) comprenant de multiples actionneurs électroconducteurs adressables individuellement, chacun d'entre eux étant positionné de manière à déformer une partie sélectionnée de la surface d'affichage dans une première direction ; **caractérisée par** une couche de sollicitation (111) comprenant de multiples parties sollicitées de manière souple, chacune d'entre elles étant positionnée de manière à correspondre à un actionneur de la couche d'actionnement (107), et
conçue de manière à accompagner la déformation de la surface déformable au niveau d'une partie sélectionnée, chacune des parties sollicitées de manière souple étant conçue pour pousser l'actionneur correspondant de la couche d'actionnement (107) dans une seconde direction opposée à la première direction,
dans laquelle la couche d'actionnement (107) est disposée entre la surface d'affichage déformable (101) et la couche de sollicitation (111), dans laquelle chacun des actionneurs électroconducteurs adressables individuellement comprend un bras anfractueux (207) avec une connexion électrique à une couche d'alimentation configurée pour fournir un courant électrique, dans laquelle la couche d'alimentation est disposée entre la couche d'actionnement (107) et la couche de sollicitation (111).

2. Structure d'affichage flexible selon la revendication 1, dans laquelle chacun des bras (207) comprend en outre une liaison mécanique à la surface d'affichage.

3. Structure d'affichage flexible selon l'une quelconque revendication précédente, dans laquelle chacun des actionneurs est conçu pour se déformer lors de l'application d'un courant électrique et/ou d'une énergie thermique.

4. Structure d'affichage flexible selon l'une quelconque revendication précédente, dans laquelle la couche d'actionnement (107) est formée d'un alliage à mémoire de forme ou d'un matériau polymère.

5. Structure d'affichage flexible selon l'une quelconque revendication précédente, dans laquelle la couche de sollicitation (111) est formée d'un matériau métallique.

6. Structure d'affichage flexible selon l'une quelconque des revendications 1 à 4, dans laquelle la couche de sollicitation (111) est formée d'un alliage à mémoire de forme ou d'un matériau polymère.

7. Structure d'affichage flexible selon l'une quelconque revendication précédente, dans laquelle les actionneurs sont régulièrement répartis dans un réseau dans la couche d'actionnement (107) sur une zone correspondant à une zone de la surface d'affichage déformable (101).

8. Structure d'affichage flexible selon l'une quelconque revendication précédente, dans laquelle la couche d'actionnement (107) et la couche de sollicitation (111) sont reliées mécaniquement.

9. Structure d'affichage flexible selon l'une quelconque revendication précédente, dans laquelle chacun des multiples actionneurs électroconducteurs adressables individuellement comprend une partie magnétique.

10. Structure d'affichage flexible selon la revendication 9, dans laquelle la partie magnétique d'un actionneur est positionnée de manière à interagir avec un capteur statique.

11. Équipement utilisateur (700) comprenant une structure d'affichage flexible selon l'une quelconque des revendications 1 à 10.

12. Équipement utilisateur (700) selon la revendication 11, dans lequel la surface d'affichage déformable (101) est une surface tactile configurée pour recevoir une entrée utilisateur.

13. Équipement utilisateur (700) selon la revendication 11 ou 12, comprenant en outre un processeur (705) couplé en communication à une mémoire (707), le processeur (705) étant configuré pour générer un signal de sortie représentant un degré de déformation de la partie sélectionnée de la surface d'affichage.

14. Équipement utilisateur (700) selon la revendication 13, dans lequel le processeur (705) est en outre configuré pour déterminer une quantité de déformation de la partie sélectionnée sur la base d'une mesure de déviation de la partie sélectionnée générée par une structure de détection magnétique.
